# EUROPÄISCHE PATENTSCHRIFT

(11) **EP 0 813 618 B1**
(45) Veröffentlichungstag und Bekanntmachung des Hinweises auf die Patenterteilung: **04.08.1999**
(21) Anmeldenummer: 96901714.4
(22) Anmeldetag: 09.02.1996
(51) Int. Cl.: C23C 18/30

(54) **VERFAHREN ZUM STROMLOSEN METALLISIEREN VON ELEKTRISCH NICHT LEITENDEN SUBSTRATEN**
CURRENTLESS METALLIZATION PROCESS FOR NON ELECTROCONDUCTIVE SUBSTRATES
PROCEDE DE METALLISATION SANS COURANT DE SUBSTRATS NON ELECTROCONDUCTEURS

(30) Priorität: 09.03.1995 DE 19508341
(43) Veröffentlichungstag der Anmeldung: 29.12.1997
(73) Patentinhaber: ROBERT BOSCH GMBH, 70442 Stuttgart (DE)
(72) Erfinder: WEBER, Lothar, D-70499 Stuttgart (DE); SCHMID, Kurt, D-71254 Ditzingen (DE); HAUG, Ralf, D-71229 Leonberg (DE); KLING, Dorothee, D-71229 Leonberg (DE)
(86) Internationale Anmeldenummer: DE9600201
(87) Internationale Veröffentlichungsnummer: WO9628588

(56) Entgegenhaltungen:
- EP-A- 0 562 393
- DE-A- 3 840 201
- 1BM TECHNICAL DISCLOSURE BULLETIN, Bd.8, Nr.9, Februar 1966 Seite 1174, XP002000481 HAINES 'metallising non conductive substrates'

## Beschreibung

Die Erfindung betrifft ein Verfahren zum stromlosen Metallisieren von elektrisch nicht leitenden Substraten nach dem Oberbegriff des Anspruchs 1.

### Stand der Technik

Verfahren zum stromlosen Metallisieren von elektrisch nicht leitenden Substraten sind bekannt. Ein derartiges Verfahren ist beispielsweise in der EP-PS 0 255 012 B1 erläutert. Hierbei wird auf dem elektrisch nicht leitenden Substrat eine bindemittelhaltige Aktivatorformulierung als Trägerschicht für die Metallisierung aufgebracht. Aus der Aktivatorformulierung, die neben Binde- und Lösungsmitteln organische Metallverbindungen enthält, wird das Lösungsmittel entfernt, die Aktivatorformulierung anschließend reduziert und das Substrat in einem allgemein bekannten Metallisierungsbad stromlos metallisiert. Bei dem bekannten Verfahren ist nachteilig, daß die Haftfestigkeit der Metallisierunng auf dem Substrat nicht für alle Anwendungsfälle, beispielsweise zum Erzeugen von Leiterbahnen mit einem extrem kleinen Rastermaß, ausreichend ist.

Die EP A 0 562 393 offenbart ein weiteres stromloses Verfahren zur Abscheidung von Metallschichten für gedruckte Schaltungen und Sensoren, das von UV-härtbaren Lacken mit organischen Edelmetallverbindungen ausgeht, die nach UV-Bestrahlung und anschließender Reduktion mit einem Reduktionsmittel aktiviert wurden. Dieses Verfahren hat jedoch den Nachteil, daß keine Möglichkeit besteht, über die Zeitdauer und Stärke bzw. Wellenlänge der UV-Strahlung die Oberfläche des Substrates gezielt so zu behandeln bzw. chemisch zu modifizieren.

In der Veröffentlichung von Haines im IBM Technical Disclosure Bulletin, Bd. 8, Nr. 9, (1966), Seite 1174 wird ein Verfahren zur stromlosen Abscheidung von Metallen beschrieben, indem ein Palladiumdimethylsulfoxidkomplex mit einem Polymerbildner oder einem Harz vermischt und auf ein Substrat aufgebracht wird. Auf das dadurch aktivierte Substrat wird anschließend durch eine UV-Bestrahlung die Palladiumverbindung entweder direkt zersetzt oder alternativ das Substrat mit einem Reduktionsmittel behandelt (keine UV-Bestrahlung). Der Nachteil dieser Vorgehensweise ist, daß zunächst in der ersten Verfahrensvariante nur UV-ab-sorbierende Palladiumverbindungen verwendet werden können. Außerdem besteht wie im Fall EP A 0 562 393 keine Möglichkeit, über die Zeitdauer und Stärke bzw. Wellenlänge der UV-Strahlung die Oberfläche des Substrates gezielt chemisch zu modifizieren.

Eine von der Reduktion der Palladiumverbindung unabhängige Fixierung in der Oberfläche des Substrates ist ebenfalls nicht möglich. Die zweite Verfahrensvariante ist zur Erzeugung von feinen Strukuren (z.B. Leiterbahnen) schlecht geeignet.

### Vorteile der Erfindung

Das erfindungsgemäße Verfahren mit den im Anspruch 1 genannten Merkmalen bietet demgegenüber den Vorteil, daß eine Metallisierung von sehr feinen Strukturen mit großer Haftfestigkeit erzielbar ist. Dadurch, daß auf das Substrat ein organische Metallverbindungen enthaltender Positivlack aufgebracht wird, der Positivlack anschießend mit UV-Licht bestrahlt und auf dem bestrahlten Positivlack die Metallisierung abgeschieden wird, ist es vorteilhaft möglich, in großer Stückzahl reporduzierbare fest haftende Metallisierungsstrukturen zu erzeugen. Das erfindungsgemäße Verfahren beinhaltet keinen wärmeintensiven Verfahrensschritt, so daß auch wärmeempfindliche Substrate, auf denen die Metallisierung aufgebracht wird, verwendet werden können.

In bevorzugter Ausgestaltung der Erfindung ist vorgesehen, daß die Bestrahlung mit UV-Licht mit einer bestimmten wählbaren Wellenlänge und/oder einer bestimmten wählbaren Zeitdauer erfolgt. Durch eine Auswahl der Wellenlänge und der Zeitdauer der Bestrahlung ist die nachfolgende Abscheidung der Metallisierung auf den bestrahlten Positivlack sehr vorteilhaft beeinflußbar. So kann die Metallisierung so eingestellt werden, daß zuerst eine Metalloxidzwischenschicht abgeschieden wird, auf der dann die eigentliche Metallisierung sich aufbaut. Hiermit wird ohne weiteren Zwischenschritt, das heißt, die Abscheidung der Zwischenschicht und der Hauptschicht erfolgt in einem Arbeitsgang, eine sehr gute Haftfestigkeit der Metallisierung auf dem Substrat erreicht. Insbesondere bei der erfindungsgemäßen Verwendung eines kurzwelligen UV-Lichtes lassen sich besonders fest haftende Metallisierungsschichten auf dem Substrat erzeugen.

In weiterer bevorzugter Ausgestaltung der Erfindung ist vorgesehen, daß zur Herstellung von elektrischen Leiterbahnen eine Metallisierung in einem Kupferbad erfolgt. Durch die gute Haftfähigkeit der Metallisierungen auf dem Substrat können sehr komplexe Schaltungen erzeugt werden, die auf kleinem Raum eine große Vernetzung aufweisen können. Ein zwischen zwei Leiterbahnen bestehender Abstand kann sehr klein gehalten werden. Weiterhin ist bevorzugt, daß zur Herstellung von elektrischen Widerständen die Metallisierung in einem Nickel- oder Nickellegierungsbad erfolgt. Hierdurch lassen sich in einfacher Weise fest haftende elektrische Widerstände in Schaltungsanordnungen erzeugen, die mittels eines einfach beherrschbaren Verfahrensschrittes in den Gesamtprozeß der Herstellung einer Leiterplatte einbindbar sind.

Weitere vorteilhafte Ausgestaltungen der Erfindung ergeben sich aus den übrigen in den Unteransprüchen genannten Merkmalen.

### Zeichnungen

Die Erfindung wird nachfolgend in Ausführungsbeispielen anhand der zugehörigen Zeichnungen näher erläutert. Es zeigen:
- Figur 1: ein Flußschema des erfindungsgemäßen Verfahrensablaufs;
- Figur 2: einen Reaktionsverlauf der Fixierung des Positivlackes während der UV-Lichtbestrahlung und
- Figur 3: verschiedene Beispiele für die Verwendung von organischen Metallverbindungen in dem Positivlack.

### Beschreibung der Ausführungsbeispiele

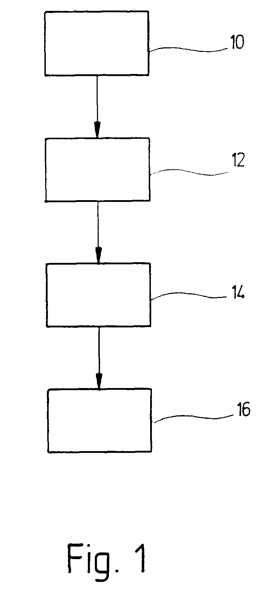

In der Figur 1 soll das erfindungsgemäße Verfahren mit Hilfe eines Diagrammes verdeutlicht werden. In einem ersten Verfahrensschritt 10 wird ein elektrisch nicht leitendes Substrat mit einer Trägerschicht für die noch zu erläuternde Metallisierung versehen. Als Substrat kann jeder beliebige organische oder anorganische Formkörper, der sowohl starr als auch flexibel ausgebildet sein kann, verwendet werden.

Nach einem konkreten Ausführungsbeispiel wird eine Polyimidfolie (Kapton) verwendet. Der Positivlack kann auf das Substrat mittels allgemein bekannter Verfahrensschritte, beispielsweise Aufsprühen, Aufpinseln, Aufrollen, Offsetdruck, Siebdruck, Tampondruck (Tiefdruck), Tauchen usw., aufgebracht werden. Eine Vorbehandlung des Substrats zum Aufbringen des Positivlackes ist nicht erforderlich. Je nach angewendetem Verfahren zum Aufbringen des Positivlackes auf das Substrat besitzt dieser eine speziell hierauf abgestimmte Zusammensetzung. Dies betrifft beispielsweise die in dem Positivlack enthaltenen Lösungsmittel, die für Tampondruck oder Siebdruck aufgrund des unterschiedlichen technologischen Ablaufs verschieden zu wählen sind. Der Positivlack enthält ferner organische Metallverbindungen, die als Aktivatoren (Keimzellen) für die nachfolgende Metallisierung dienen.

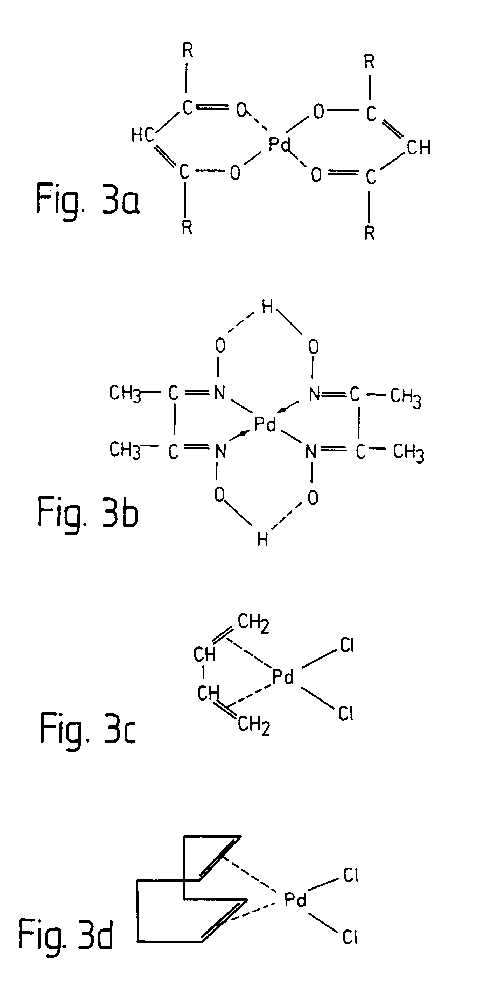

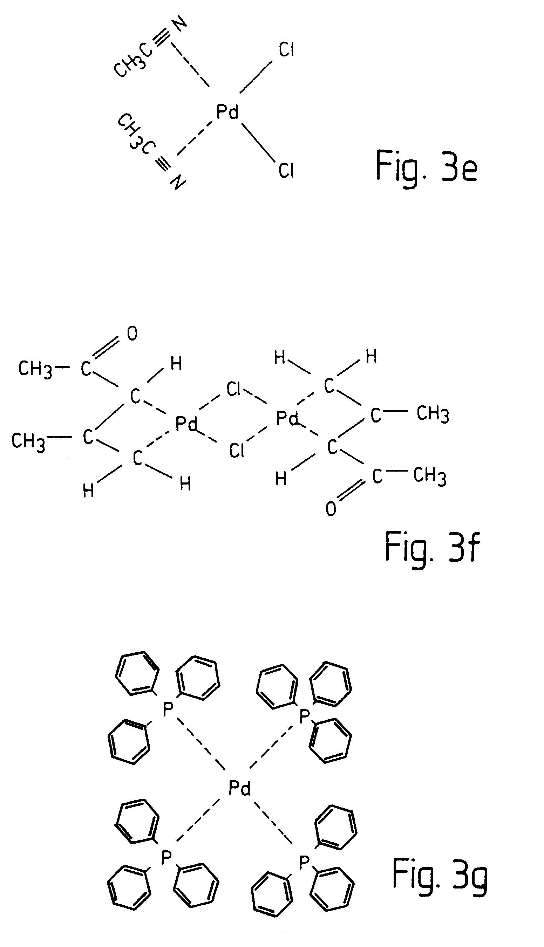

Gemäß einem konkreten Ausführungsbeipiel werden als organische Metallverbindungen in organischen Lösungsmitteln lösliche Palladiumverbindungen verwendet. Dies können beispielsweise die in Figur 3 mit ihrer chemischen Formel dargestellten Verbindungen sein.

So können
gemäß a) Palladiumacetylacetonat (R=CH₃) und Phenylderivat (R=C₆H₅),
gemäß b) Palladiumglyoximat,
gemäß c) Dichlor (1,3-Butadienyl)Palladium (II),
gemäß d) Dichlorcyclooctadienyl-(1,5)-Palladium (II),
gemäß e) Dichlorobis-(acetonitril)Palladium (II),
gemäß f) π-Allylcomplex und
gemäß g) Tetrakis-(triphenylphosphin)Palladium (0) als Palladiumverbindungen Verwendung finden.

Dieser, die Palladiumverbindungen und hier nicht weiter zu betrachtende Lösungsmittel, Bindemittel, Farbstoffe usw. enthaltende Positivlack wird in einem wählbaren Layout auf das Substrat aufgetragen. Hierbei kann ein großflächiges oder selektives Auftragen auf die Oberfläche des Substrates erfolgen. Im Sinne der Erfindung wird unter Positivlack ein Lack verstanden, der lichtaktive Komponenten enthält, die bei Einwirkung von Licht eine chemische Änderung der Zusammensetzung des Positivlacks bewirken.

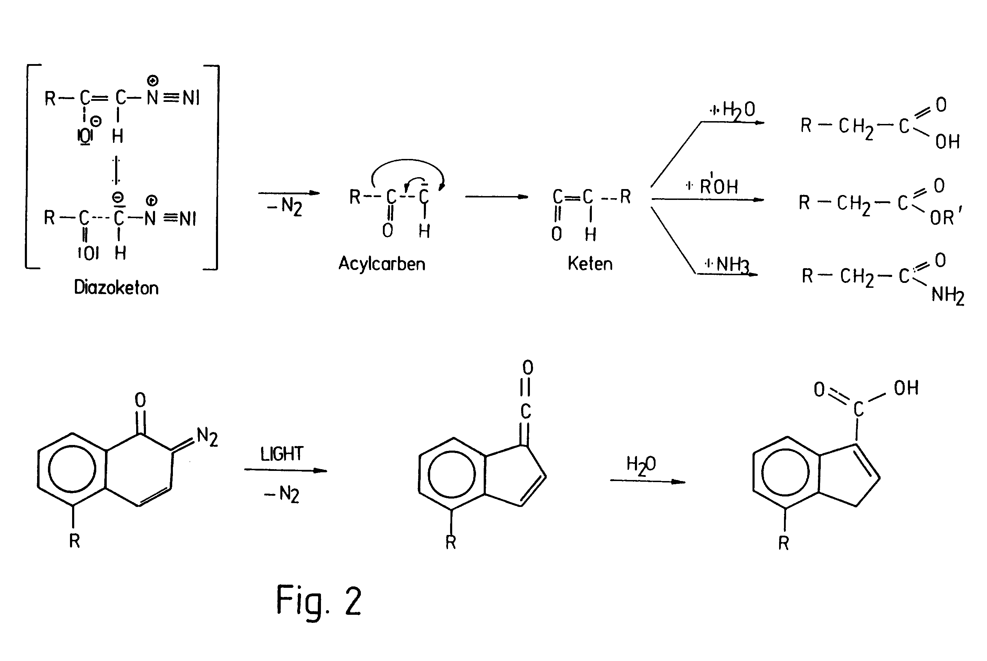

In einem nächsten Verfahrensschritt 12 wird das mit dem Positivlack beschichtete Substrat mit einer UV-Lichtquelle bestrahlt. Die Bestrahlung mittels des UV-Lichtes löst in dem Positivlack eine Reaktion aus, die anhand der Figur 2 verdeutlicht ist. Die lichtaktive Komponente des Positivlackes ist beispielsweise ein Diazoketon, das bei Belichtung mittels des UV-Lichtes unter Abspaltung von Stickstoff nach der sogenannten Wolf-Umlagerung ein Keten bildet. Dieses Keten stabilisiert sich dann nach der Arndt-Eistert-Reaktion im Gegenwart der Luftfeuchtigkeit (H₂O) unter Bildung einer Karbonsäure. Während der hier ablaufenden Komplexierungsreaktion wird die in dem Positivlack als Aktivator enthaltene Palladiumverbindung fixiert. Der Positivlack ergibt nach der Belichtung mit dem UV-Licht mit der Palladiumverbindung eine stabile Verbindung, die auf der Oberfläche des Substrats gut fixiert ist. Durch die Bestrahlung des Positivlackes mit dem UV-Licht werden auf der Oberfläche Sauerstoffverbindungen erzeugt, die die nachfolgende Metallisierung entscheidend beeinflussen.

Die Belichtung mit dem UV-Licht kann, abgestimmt auf die nachfolgende Metallisierung, variiert werden. So ist insbesondere eine Belichtung mit dem UV-Licht für eine wählbare Zeitspanne und/oder mit einem UV-Licht mit wählbarer Wellenlänge möglich. Nach einem konkreten Ausführungsbeispiel wird beispielsweise eine Belichtung mittels einer UV-Lichtquelle für 10 Minuten durchgeführt, die eine Bestrahlungsstärke von 15...150 mW/cm² und die Wellenlängen vorweisen, die auf das gesamte Lacksystem, einschließlich Palladiumkomponenten, angepaßt sind. Die geeigneten Wellenlängen liegen beispielsweise bei 222, 308, 356 und 400 nm. Über eine Variation der Bestrahlungsstärke, die Wellenlänge des UV-Lichtes und die Behandlungsdauer kann auf die Bildung der Sauerstoffverbindungen auf der Oberfläche des Substrats Einfluß genommen werden. Je nach Anzahl und Art der vorhandenen Sauerstoffverbindungen ergibt sich eine unterschiedliche Metallisierung des Substrats.

In einem nächsten Verfahrensschritt 14 wird die mit den Palladiumverbindungen versehene Oberfläche des Substrats einer Reduktion unterzogen. Hierbei wird beispielsweise das Substrat in ein Reduktionsbad, vorzugsweise in eine NaBH₄-Lösung gegeben, so daß die in einer Oxidationsstufe vorliegenden Palladiumverbindungen reduziert werden und anschließend ein nullwertiges Palladium vorliegt. Die an der Oberfläche des Substrates befindlichen Sauerstoffverbindungen bleiben bei diesem Verfahrensschritt unverändert.

In einem letzten Verfahrensschritt 16 wird das Substrat in ein Metallisierungsbad gegeben. Das Metallisierungsbad kann beispielsweise ein Kupferbad sein. Hierbei erfolgt eine stromlose Verkupferung des Substrats an den zuvor mit dem palladiumhaltigen Positivlack versehenen Bereichen des Substrats. In dem Kupferbad erfolgt eine stromlose Verkupferung, indem aus dem Kuperbad abgeschiedenes Kupfer mit dem mit dem UV-Licht bestrahlten Positivlack reagiert. Hierbei verbindet sich das Kupfer mit den auf der Substratoberfläche vorhandenen Sauerstoffverbindungen zunächst zu Kupferoxid CuO, das sich auf der Substratoberfläche niederschlägt. Dieses Kupferoxid bildet eine Zwischenschicht, die als Haftvermittler zwischen dem Substrat und der nachfolgenden eigentlichen Metallisierung dient. Nachdem die freien Sauerstoffverbindungen auf der Substratoberfläche zur Bildung der Kupferoxidschicht verbraucht sind, scheidet sich hierauf reines metallisches Kupfer ab. Somit findet während eines Verfahrensschrittes gleichzeitig die Abscheidung einer Haftvermittlerschicht und die Abscheidung der eigentlichen Metallisierungsschicht statt. Hierdurch kommt es zu einer sehr guten Haftfestigkeit der Metallisierungsschicht auf dem Substrat. Je nach dem gewählten Layout, mit dem der mit den Palladiumverbindungen angereicherte Positivlack auf dem Substrat aufgebracht wurde, können die Substrate mit Leiterbahnen oder größeren Metallisierungsbereichen (hier Kupfer) jeder beliebigen Geometrie versehen werden. So lassen sich beispielsweise sehr gut haftende Leiterbahnen erzielen, die beispielsweise eine Breite von 65 µm oder kleiner, eine Dicke von 2...3 µm und einen Abstand untereinander von ebenfalls 65 µm und kleiner aufweisen. Durch die gute Haftfestigkeit der Metallisierung sind diese kleinen Rastermaße in hoher Qualität erzielbar. Im Bedarfsfalle kann eine galvanische Verstärkung der Leiterbahnen durch ein nachfolgendes galvanisches Abscheiden von Kupfer erzielt werden.

Nach einem weiteren Ausführungsbeispiel kann anstelle des Kupferbades beispielsweise ein Nickel- oder Nickellegierungsbad verwendet werden. Hierdurch sind auf dem Substrat Metallisierungsschichten aus Nickel beziehungsweise einer Nickellegierung erzielbar, die sehr vorteilhaft als elektrische Widerstandsschichten in bestehende Schaltungsanordnungen integrierbar sind.

Durch eine sehr vorteilhafte Kombination der Behandlung der Substrate können Schaltungsanordnungen geschaffen werden, die sowohl elektrische Leiterbahnen als auch elektrische Widerstände aufweisen. Durch eine Kombination oder Wiederholung der Abfolge der einzelnen Verfahrensschritte können beispielsweise zuerst Leiterbahnen auf dem Substrat strukturiert werden und anschließend die entsprechenden Widerstandsschichten vorgesehen werden. Hierzu kann ein mehrmaliges Aufbringen des palladiumhaltigen Positivlackes auf das Substrat erfolgen, das heißt, nachdem ein erstes Mal der Positivlack aufgetragen, mit UV-Licht belichtet und in einem Kupferbad verkupfert wurde, kann auf das die bereits die Leiterbahnen aufweisende Substrat in einem nächsten Verfahrensschritt wiederum ein palladiumhaltger Positivlack aufgebracht werden, der nachfolgend entsprechend belichtet und mit den Widerstandsschichten versehen wird.

Die Beschichtung des Substrats mit Kupfer oder Nickel beziehungsweise Nickellegierungen ist lediglich beispielhaft. So kann selbstverständlich eine Metallisierung mit jedem anderen geeigneten Metall erfolgen. Insgesamt ist für das erfindungsgemäße Verfahren entscheidend, daß sämtliche Verfahrensschritte bei Raumtemperatur durchgeführt werden, so daß auf wärmeempfindliche Substrate keine Rücksicht genommen werden muß. Es ist aber durchaus möglich, einzelne Verfahrensschritte auch bei höheren Temperaturen durchzuführen. Darüber hinaus sind zusätzliche Wärmequellen, beispielsweise zur Erwärmung der Metallisierungsbäder und/oder zum Aufbringen der Positivlackschicht, nicht notwendig, so daß gegenüber herkömmlichen Verfahren eine Energieeinsparung möglich ist. Mittels des erfindungsgemäßen Verfahrens zum stromlosen Metallisieren sind sehr feine und fest haftende Strukturen erzielbar. Insbesondere durch das nacheinanderfolgende Abscheiden der Haftschicht und der eigentlichen Metallisierungsschicht in einem Verfahrensschritt ergeben sich sehr gute Haftfestigkeitswerte der Metallisierung auf dem Substrat.

## Patentansprüche

1. Verfahren zum stromlosen Metallisieren von elektrisch nicht leitenden Substraten auf Polymerbasis mit einer Schicht aus einem UV-härtbaren Positivlack, der eine metallorganische Palladiumverbindung enthält, **dadurch gekennzeichnet,** daß das Substrat mit UV-Strahlung wählbarer Wellenlänge, Zeitdauer und Bestrahlungsstärke behandelt wird, derart, daß Sauerstoffverbindungen des oder der Polymere an der Substratoberfläche entstehen und daß das mit UV-Strahlung behandelte Substrat vor der stromlosen Metallisierung einer Reduktion unterzogen wird.

2. Verfahren nach Anspruch 1, dadurch gekennzeichnet, daß die Wellenlänge der UV-Strahlung zwischen 222 und 400 nm eingestellt wird.

3. Verfahren nach Anspruch 1, dadurch gekennzeichnet, daß die Reduktion mit einem Reduktionsmittel in einem Reduktionsbad erfolgt.

4. Verfahren nach Anspruch 1 bis 3, dadurch gekennzeichnet, daß zu Beginn des stromlosen Metallisationsprozesses zuerst eine Metalloxidzwischenschicht auf dem Substrat abgeschieden wird.

5. Verfahren nach Anspruch 4, dadurch gekennzeichnet, daß auf die Metalloxidzwischenschicht eine Metallschicht abgeschieden wird.

6. Verfahren nach Anspruch 1, dadurch gekennzeichnet, daß als Polymerbasis Polyimide, insbesondere Kapton, verwendet werden.

7. Verfahren nach Anspruch 1, dadurch gekennzeichnet, daß zuerst eine Metallisierung in einem Kupferbad und anschließend in einem Nickel- oder Nickellegierungsbad erfolgt.

## Revendications

1. Procédé de métallisation non électrique de substrats non électroconducteurs à base de polymère avec une couche de vernis positif durcissable au rayonnement UV, contenant une combinaison métallo-organique de palladium,
caractérisé en ce qu'
• on traite le substrat avec un rayonnement UV de longueur d'onde, de durée et d'intensité, choisies, pour développer des combinaisons d'oxygène du ou des polymère(s) à la surface du substrat et
• on soumet le substrat ainsi traité au rayonnement UV, à une réduction avant la métallisation non électrique.

2. Procédé selon la revendication 1,
caractérisé en ce qu'
on règle la longueur d'onde du rayonnement UV à une valeur comprise entre 222 et 400 nm.

3. Procédé selon la revendication 1,
caractérisé en ce qu'
on effectue la réduction avec un agent réducteur dans un bain réducteur.

4. Procédé selon les revendications 1 à 3,
caractérisé en ce qu'
au début du procédé de métallisation non électrique on dépose tout d'abord une couche intermédiaire d'oxyde métallique sur le substrat.

5. Procédé selon la revendication 4,
caractérisé en ce qu'
on dépose une couche métallique sur la couche intermédiaire d'oxyde métallique.

6. Procédé selon la revendication 1,
caractérisé en ce que
comme base de polymère on utilise des polyimides, notamment du Kapton.

7. Procédé selon la revendication 1,
caractérisé en ce qu'
on métallise dans un bain de cuivre puis dans un bain de nickel ou d'un alliage de nickel.

## Claims

1. Process for the currentless metallization of electrically nonconductive polymer-based substrates with a layer of a UV-curable positive resist which contains an organometallic palladium compound, characterized in that the substrate is treated with UV radiation of selectable wavelength, duration and irradiance, in such a way that oxygen compounds of the polymer or polymers form on the substrate surface and that the substrate treated with UV radiation is subjected to a reduction before the currentless metallization.

2. Process according to Claim 1, characterized in that the wavelength of the UV radiation is adjusted to between 222 and 400 nm.

3. Process according to Claim 1, characterized in that the reduction is effected with a reducing agent in a reducing bath.

4. Process according to any of Claims 1 to 3, characterized in that, at the beginning of the currentless metallization process, a metal oxide intermediate layer is first deposited on the substrate.

5. Process according to Claim 4, characterized in that a metal layer is deposited on the metal oxide intermediate layer.

6. Process according to Claim 1, characterized in that the polymer base used comprises polyimides, in particular Kapton.

7. Process according to Claim 1, characterized in that a metallization is effected first in a copper bath and then in a nickel or nickel alloy bath.
